Europäisches Patentamt

**European Patent Office**

**Office européen des brevets**

(19)

(11) Veröffentlichungsnummer: **0 081 055**
**B1**

(12) **EUROPÄISCHE PATENTSCHRIFT**

(45) Veröffentlichungstag der Patentschrift:
**24.07.85**

(21) Anmeldenummer: **82109176.6**

(22) Anmeldetag: **05.10.82**

(51) Int. Cl.⁴: **G 03 C 7/00,** G 03 F 1/00,
G 03 F 7/02, G 02 B 5/20

(54) **Aufzeichnungsträger mit einer mehrfarbigen Feinstruktur, insbesondere in Form einer Mikrolandkarte, und Verfahren zur Herstellung des Aufzeichnungsträgers.**

(30) Priorität: **04.12.81 DE 3147985**

(43) Veröffentlichungstag der Anmeldung:
**15.06.83 Patentblatt 83/24**

(45) Bekanntmachung des Hinweises auf die Patenterteilung:
**24.07.85 Patentblatt 85/30**

(84) Benannte Vertragsstaaten:
**AT CH FR GB IT LI NL SE**

(56) Entgegenhaltungen:
**DE - A - 2 656 409**
**FR - A - 1 584 726**
**FR - A - 2 375 619**
**US - A - 4 124 473**
**US - A - 4 155 627**

(73) Patentinhaber: **Dr. Johannes Heidenhain GmbH,
Nansenstrasse 17, D-8225 Traunreut (DE)**

(72) Erfinder: **Bayer, Erich, Friedrich-Ebert-Strasse 1,
D-8223 Trostberg (DE)**
Erfinder: **Beckerbauer, Anton, Biebinger Strasse 10,
D-8221 Nussdorf (DE)**
Erfinder: **Flatscher, Georg, Dr., Waldeck 7,
D-8230 Schneizlreuth (DE)**
Erfinder: **Ullrich, Martin, Hasselberg 6,
D-8222 Ruhpolding (DE)**

## Beschreibung

Die Erfindung betrifft einen Aufzeichnungsträger mit einer mehrfarbigen Feinstruktur gemäss dem Oberbegriff des Anspruchs 1.

In der US-A Nr. 3727233 ist eine Methode zur Aufzeichnung eines mehrfarbigen Bildes beschrieben, bei der auf einem Schichtträger aus Glas eine Metallschicht hoher Reflektivität und darauf eine organische Polymerschicht aufgebracht werden. Die Polymerschicht wird mittels ein abzubildendes Objekt durchdringender Elektronenstrahlen belichtet sowie anschliessend entwickelt und besitzt danach durch Polymerisation eine Struktur entsprechend der Bestrahlungsintensität der Elektronenstrahlen. Anschliessend wird auf die strukturierte organische Polymerschicht eine weitere Metallschicht hoher Reflektivität aufgebracht, so dass sich infolge Interferenz ein mehrfarbiges Bild bei natürlichem Licht ergibt. Als nachteilig erweist es sich, dass die über den gesamten Schichtträger mit gleicher Schichtdicke aufgebrachten Metallschichten keine unterschiedlichen Sättigungen der einzelnen Farbtöne des Bildes erlauben. Die strukturierte Interferenzschicht in Form der organischen Polymerschicht lässt wegen ihrer erheblichen Wärmeempfindlichkeit eine starke Rückvergrösserung des mehrfarbigen Bildes wegen der damit verbundenen hohen Beleuchtungsstärken nicht zu; durch die mangelnde Lichtechtheit und Schrumpfung der organischen Inteferenzschicht im Laufe der Zeit können zudem Farbveränderungen auftreten.

Aus der DE-A Nr. 2658623 ist ein Aufzeichnungsträger mit einer Aufzeichnung hoher Informationsdichte, insbesondere mit einem mehrfarbigen Mikrobild bekannt, bei dem auf einem Schichtträger wenigstens zwei Interferenzfilter für zwei unterschiedliche Farbtöne vorgesehen sind. Jedes Interferenzfilter besteht aus einer unstrukturierten anorganischen absorptionsfreien Interferenzschicht, die sich mit gleicher Schichtdicke über den gesamten Schichtträger erstreckt und auf jeder Seite durch wenigstens eine die Struktur der Aufzeichnung bildende anorganische spiegelnde Schicht begrenzt ist. In einer weiteren Ausbildung ist die unstrukturierte Interferenzschicht auf jeder Seite durch wenigstens eine strukturierte hochbrechende absorptionsfreie Schicht begrenzt, wobei sich zwischen je zwei hochbrechenden Schichten eine unstrukturierte niedrigbrechende absorptionsfreie Schicht befindet. Da sich zwischen den die Struktur bildenden spiegelnden Schichten die unstrukturierte Interferenzschicht bzw. zwischen den die Struktur bildenden hochbrechenden Schichten die unstrukturierte Interferenzschicht und die unstrukturierten niedrigbrechenden Schichten befinden, die sich ebenfalls mit gleicher Schichtdicke über den gesamten Schichtträger erstrecken, sind für jeden Farbton eine Reihe von Strukturierungsschritten erforderlich, bei denen aber die Mehrfachjustierung der betreffenden Belichtungsmaske grösste Justiergenauigkeit erfordert und ausserdem zeitaufwendig ist.

Der Erfindung liegt die Aufgabe zugrunde, bei einem Aufzeichnungsträger der oben genannten Gattung die Anzahl der Verfahrensschritte zu reduzieren, Justierungsprobleme zu vermeiden und die optische Güte der Feinstruktur zu verbessern.

Diese Aufgabe wird erfindungsgemäss im wesentlichen durch die kennzeichnenden Merkmale des Anspruchs 1 gelöst.

Die mit der Erfindung erzielten Vorteile bestehen insbesondere darin, dass bei der Herstellung eines solchen Aufzeichnungsträgers der Zeit- und Kostenfaktor sowie die Ausschussrate erheblich gesenkt und eine bessere Farbtonreinheit und Farbtonsättigung erzielt werden.

Vorteilhafte Ausgestaltungen sowie Verfahren zur Herstellung derartiger Aufzeichnungsträger entnimmt man den Unteransprüchen.

Ausführungsbeispiele der Erfindung sind in der Zeichnung dargestellt und werden im folgenden näher erläutert. Es zeigen:

Fig. 1a bis 1c Aufzeichnungsträger mit metalldieleketrischen Interferenzfiltern,

Fig. 2a, 2b Aufzeichnungsträger mit reindielektrischen Interferenzfiltern,

Fig. 3a, 3b Aufzeichnungsträger mit Halbfiltern,

Fig. 4a bis 4d Aufzeichnungsträger mit induzierten Transmissionsfiltern,

Fig. 5a, 5b Aufzeichnungsträger mit Kantenfiltern (Reflektoren) und

Fig. 6a, 6b Aufzeichnungsträger mit Kantenfiltern und metalldielektrischen Filtern.

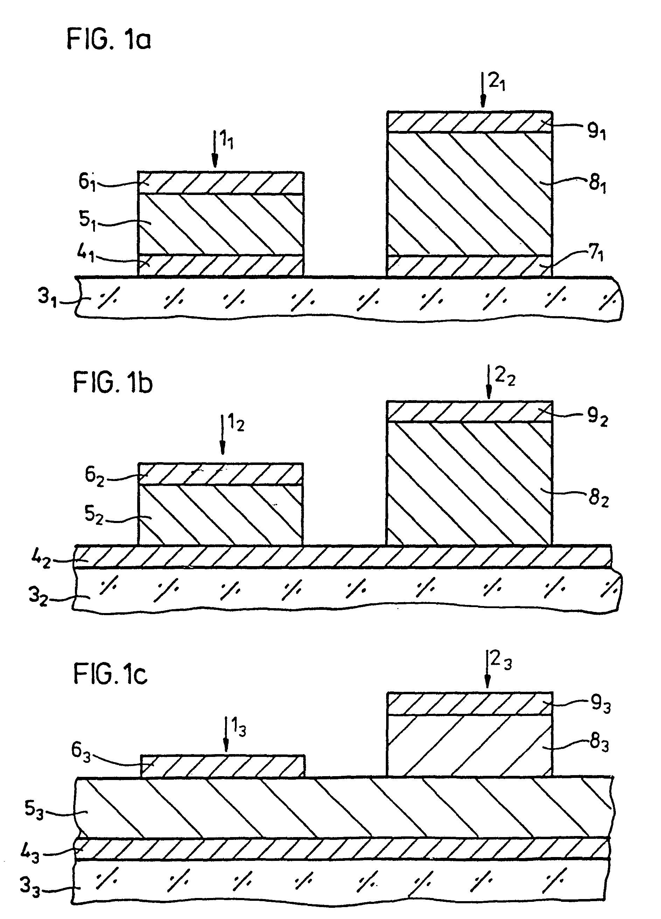

In Fig. 1a bis 1c sind Aufzeichnungsträger mit metalldielektrischen Interferenzfiltern in Form von Schichtpaketen $1_1, 1_2, 1_3$ für einen ersten Farbton und von Schichtpaketen $2_1, 2_2, 2_3$ für einen zweiten Farbton dargestellt.

Zur Erzeugung des ersten Farbtons wird gemäss Fig. 1a auf einem Schichtträger $3_1$ in nicht gezeigter Weise ganzflächig eine erste Photolackschicht aufgebracht und mittels einer ersten Belichtungsmaske belichtet. Nach dem Entwickeln der ersten Photolackschicht werden auf dem Schichtträger $3_1$ ganzflächig eine Metallschicht $4_1$, eine anorganische absorptionsfreie Interferenzschicht $5_1$ gemäss dem ersten Farbton und eine Metallschicht $6_1$ aufgebracht. Die verbliebene erste Photolackschicht mitsamt den darüber befindlichen Schichten $4_1$-$6_1$ wird sodann entfernt, so dass das Schichtpaket $1_1$ auf dem Schichtträger $3_1$ verbleibt. Zur Erzeugung des zweiten Farbtons wird auf dem Schichtträger $3_1$ ganzflächig eine zweite Photolackschicht aufgebracht und mittels einer zweiten Belichtungsmaske belichtet. Nach dem Entwickeln der zweiten Photolackschicht werden auf dem Schichtträger $3_1$ ganzflächig eine Metallschicht $7_1$, eine anorganische absorptionsfreie Interferenzschicht $8_1$ gemäss dem zweiten Farbton und eine Metallschicht $9_1$ aufgebracht. Die verbliebene zweite Photolackschicht mitsamt den darüber befindlichen Schichten $7_1$-$9_1$ wird sodann entfernt, so dass neben dem Schichtpaket $1_1$ das Schichtpaket $2_1$ auf dem Schichtträger $3_1$ verbleibt.

In einer anderen Ausbildung dieses Aufzeichnungsträgers werden nach Fig. 1b auf einem

Schichtträger $3_2$ ganzflächig eine Metallschicht $4_2$ und darüber zur Erzeugung des ersten Farbtons eine erste Photolackschicht aufgebracht. Nach dem Belichten der ersten Photolackschicht mittels der ersten Belichtungsmaske und dem Entwickeln der ersten Photolackschicht werden auf der Metallschicht $4_2$ ganzflächig eine anorganische absorptionsfreie Interferenzschicht $5_2$ gemäss dem ersten Farbton und eine Metallschicht $6_2$ aufgebracht. Die verbliebene erste Photolackschicht mitsamt den darüber befindlichen Schichten $5_2$, $6_2$ wird sodann entfernt, so dass das Schichtpaket $1_2$ auf dem Schichtträger $3_2$ verbleibt. Zur Erzeugung der zweiten Farbtons wird auf der Metallschicht $4_2$ ganzflächig eine zweite Photolackschicht aufgebracht und mittels der zweiten Belichtungsmaske belichtet. Nach dem Entwickeln der zweiten Photolackschicht werden auf der Metallschicht $4_2$ ganzflächig eine anorganische absorptionsfreie Interferenzschicht $8_2$ gemäss dem zweiten Farbton und eine Metallschicht $9_2$ aufgebracht. Die verbliebene zweite Photolackschicht mitsamt den darüber befindlichen Schichten $8_2$, $9_2$ wird sodann entfernt, so dass neben dem Schichtpaket $1_2$ das Schichtpaket $2_2$ auf dem Schichtträger $3_2$ verbleibt.

In einer weiteren Ausbildung dieses Aufzeichnungsträgers werden nach Fig. 1c auf einem Schichtträger $3_3$ ganzflächig eine Metallschicht $4_3$ und darüber zur Erzeugung des ersten Farbtons eine anorganische absorptionsfreie Interferenzschicht $5_3$ aufgebracht, die nachfolgend ganzflächig mit einer ersten Photolackschicht bedeckt wird. Nach dem Belichten der ersten Photolackschicht mittels der ersten Belichtungsmaske und dem Entwickeln der ersten Photolackschicht wird auf dem Schichtträger $3_3$ ganzflächig eine Metallschicht $6_3$ aufgebracht. Die verbliebene erste Photolackschicht mitsamt der darüber befindlichen Metallschicht $6_3$ wird sodann entfernt, so dass das Schichtpaket $1_3$ auf dem Schichtträger $3_3$ verbleibt. Zur Erzeugung des zweiten Farbtons wird auf dem Schichtträger $3_3$ ganzflächig eine zweite Photolackschicht aufgebracht und mittels der zweiten Belichtungsmaske belichtet. Nach den Entwickeln der zweiten Photolackschicht werden auf dem Schichtträger $3_3$ ganzflächig eine anorganische absorptionsfreie Interferenzschicht $8_3$ und eine Metallschicht $9_3$ aufgebracht. Die verbliebene zweite Photolackschicht mitsamt den darüber befindlichen Schichten $8_3$, $9_3$ wird sodann entfernt, so dass neben dem Schichtpaket $1_3$ das Schichtpaket $2_3$ auf dem Schichtträger $3_3$ verbleibt.

Im Bereich des Schichtpakets $2_3$ bilden die Interferenzschichten $5_3$, $8_3$ zusammen die Interferenzschicht für den zweiten Farbton. Bei dem Schichtpaket $1_1$ bilden die Schichten $4_1$, $5_1$, $6_1$, bei dem Schichtpaket $1_2$ die Schichten $5_2$, $6_2$, bei dem Schichtpaket $1_3$ die Schicht $6_3$, bei dem Schichtpaket $2_1$ die Schichten $7_1$, $8_1$, $9_1$, bei dem Schichtpaket $2_2$ die Schichten $8_2$, $9_2$ und bei dem Schichtpaket $2_3$ die Schichten $8_3$, $9_3$ jeweils den strukturbildenden Teil. Die Metallschichten 4, 6, 7, 9 sind teildurchlässige Schichten.

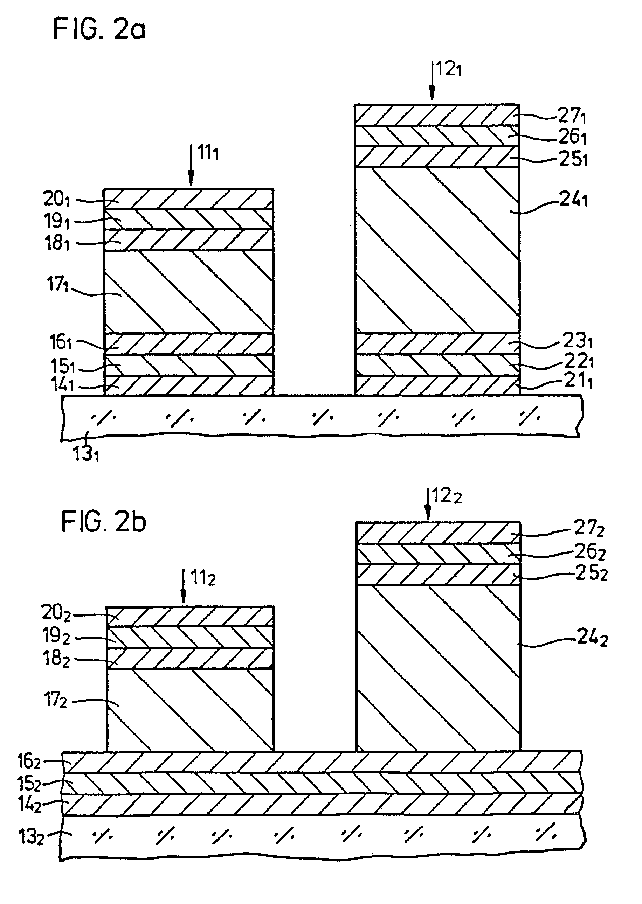

In Fig. 2a, 2b sind Aufzeichnungsträger mit reindielektrischen Interferenzfiltern in Form von Schichtpaketen $11_1$, $11_2$ für einen ersten Farbton und von Schichtpaketen $12_1$, $12_2$ für einen zweiten Farbton dargestellt.

Zur Erzeugung des ersten Farbtons wird gemäss Fig. 2a auf einem Schichtträger $13_1$ in nicht gezeigter Weise ganzflächig eine erste Photolackschicht aufgebracht und mittels einer ersten Belichtungsmaske belichtet. Nach dem Entwickeln der ersten Photolackschicht werden auf dem Schichtträger $13_1$ ganzflächig eine hochbrechende absorptionsfreie Schicht $14_1$, eine niedrigbrechende absorptionsfreie Schicht $15_1$, eine hochbrechende absorptionsfreie Schicht $16_1$, eine anorganische absorptionsfreie Interferenzschicht $17_1$ gemäss dem ersten Farbton, eine hochbrechende absorptionsfreie Schicht $18_1$, eine niedrigbrechende absorptionsfreie Schicht $19_1$ und eine hochbrechende absorptionsfreie Schicht $20_1$ aufgebracht. Die verbliebene erste Photolackschicht mitsamt den darüber befindlichen Schichten $14_1$-$20_1$ wird sodann entfernt, so dass das Schichtpaket $11_1$ auf dem Schichtträger $13_1$ verbleibt. Zur Erzeugung des zweiten Farbtons wird auf dem Schichtträger $13_1$ ganzflächig eine zweite Photolackschicht aufgebracht und mittels einer zweiten Belichtungsmaske belichtet. Nach dem Entwickeln der zweiten Photolackschicht werden auf dem Schichtträger $13_1$ ganzflächig eine hochbrechende absorptionsfreie Schicht $21_1$, eine niedrigbrechende absorptionsfreie Schicht $22_1$, eine hochbrechende absorptionsfreie Schicht $23_1$, eine anorganische absorptionsfreie Interferenzschicht $24_1$ gemäss dem zweiten Farbton, eine hochbrechende absorptionsfreie Schicht $25_1$, eine niedrigbrechende absorptionsfreie Schicht $26_1$ und eine hochbrechende absorptionsfreie Schicht $27_1$ aufgebracht. Die verbliebene zweite Photolackschicht mitsamt den darüber befindlichen Schichten $21_1$-$27_1$ wird sodann entfernt, so dass neben dem Schichtpacket $11_1$ das Schichtpaket $12_1$ auf dem Schichtträger $13_1$ verbleibt.

In einer anderen Ausbildung dieses Aufzeichnungsträgers werden nach Fig. 2b auf einem Schichtträger $13_2$ ganzflächig eine hochbrechende absorptionsfreie Schicht $14_2$, eine niedrigbrechende absorptionsfreie Schicht $15_2$ und eine hochbrechende absorptionsfreie Schicht $16_2$ sowie zur Erzeugung des ersten Farbtons darüber eine erste Photolackschicht aufgebracht. Nach dem Belichten der ersten Photolackschicht mittels der ersten Belichtungsmaske und dem Entwickeln der ersten Photolackschicht werden auf der Schicht $16_2$ ganzflächig eine anorganische absorptionsfreie Interferenzschicht $17_2$ gemäss dem ersten Farbton, eine hochbrechende absorptionsfreie Schicht $18_2$, eine niedrigbrechende absorptionsfreie Schicht $19_2$ und eine hochbrechende absorptionsfreie Schicht $20_2$ aufgebracht. Die verbliebene erste Photolackschicht mitsamt den darüber befindlichen Schichten $17_2$-$20_2$ wird sodann entfernt, so dass das Schichtpaket $11_2$ auf dem Schichtträger $13_2$ verbleibt. Zur Erzeugung des zweiten Farbtons wird auf der Schicht $16_2$ ganz-

flächig eine zweite Photolackschicht aufgebracht und mittels der zweiten Belichtungsmaske belichtet. Nach dem Entwickeln der zweiten Photolackschicht werden auf der Schicht $16_2$ ganzflächig eine Interferenzschicht $24_2$ gemäss dem zweiten Farbton, eine hochbrechende absorptionsfreie Schicht $25_2$, eine niedrigbrechende absorptionsfreie Schicht $26_2$ und eine hochbrechende absorptionsfreie Schicht $27_2$ aufgebracht. Die verbliebene zweite Photolackschicht mitsamt den darüber bedindlichen Schichten $24_2$-$27_2$ wird sodann entfernt, so dass neben dem Schichtpaket $11_2$ das Schichtpaket $12_2$ auf dem Schichtträger $13_2$ verbleibt.

Bei dem Schichtpaket $11_1$ bilden die Schichten $14_1$-$20_1$, bei dem Schichtpaket $11_2$ die Schichten $17_2$-$20_2$, bei dem Schichtpaket $12_1$ die Schichten $21_1$-$27_1$ und bei dem Schichtpaket $12_2$ die Schichten $24_2$-$27_2$ jeweils den strukturbildenden Teil.

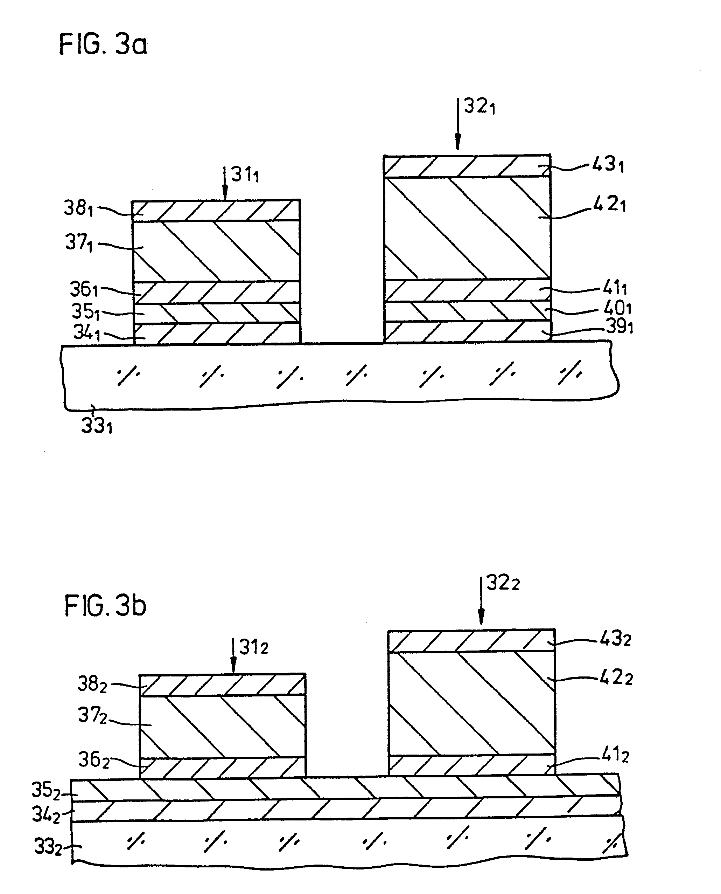

In Fig. 3a, 3b sind Aufzeichnungsträger mit Halbfiltern in Form von Schichtpaketen $31_1$, $31_2$ für einen ersten Farbton und von Schichtpaketen $32_1$, $32_2$ für einen zweiten Farbton dargestellt. Das Schichtpaket $31_1$ auf einem Schichtträger $33_1$ besteht aus einer hochbrechenden absorptionsfreien Schicht $34_1$, einer niedrigbrechenden absorptionsfreien Schicht $35_1$, einer hochbrechenden absorptionsfreien Schicht $36_1$, einer anorganischen absorptionsfreien Interferenzschicht $37_1$ gemäss dem ersten Farbton und einer Metallschicht $38_1$; die Schichten $34_1$-$38_1$ bilden den strukturbildenden Teil des Schichtpakets $31_1$. Das Schichtpaket $32_1$ auf dem Schichtträger $33_1$ besteht aus einer hochbrechenden absorptionsfreien Schicht $39_1$, einer niedrigbrechenen absorptionsfreien Schicht $40_1$, einer hochbrechenden absorptionsfreien Schicht $41_1$, einer anorganischen absorptionsfreien Interferenzschicht $42_1$ gemäss dem zweiten Farbton und einer Metallschicht $43_1$; die Schichten $39_1$-$43_1$ bilden den strukturbildenden Teil des Schichtpakets $32_1$. Das Schichtpaket $31_2$ auf einem Schichtträger $33_2$ besteht aus einer ganzflächigen hochbrechenden absorptionsfreien Schicht $34_2$, einer ganzflächigen niedrigbrechenen absorptionsfreien Schicht $35_2$, einer hochbrechenden absorptionsfreien Schicht $36_2$, einer anorganischen absorptionsfreien Interferenzschicht $37_2$ gemäss dem ersten Farbton und einer Metallschicht $38_2$; die Schichten $36_2$-$38_2$ bilden den strukturbildenden Teil des Schichtpakets $31_2$, während die ganzflächigen Schichten $34_2$, $35_2$ nicht zur Strukturbildung beitragen. Das Schichtpaket $32_2$ auf dem Schichtträger $33_2$ besteht aus der ganzflächigen hochbrechenden absorptionsfreien Schicht $34_2$, der ganzflächigen niedrigbrechenen absorptionsfreien Schicht $35_2$, einer hochbrechenden absorptionsfreien Schicht $41_2$, einer anorganischen absorptionsfreien Interferenzschicht $42_2$ gemäss dem zweiten Farbton und einer Metallschicht $43_2$; die Schichten $41_2$-$43_2$ bilden den strukturbildenden Teil des Schichtpakets $32_2$, während die ganzflächigen Schichten $34_2$, $35_2$ nicht zur Strukturbildung beitragen. Die Aufzeichnungsträger gemäss Fig. 3a, 3b werden auf photolithographischem Weg in der vorgehend beschriebenen Weise erzeugt. Die Metallschichten 38, 43 sind teildurchlässige Schichten.

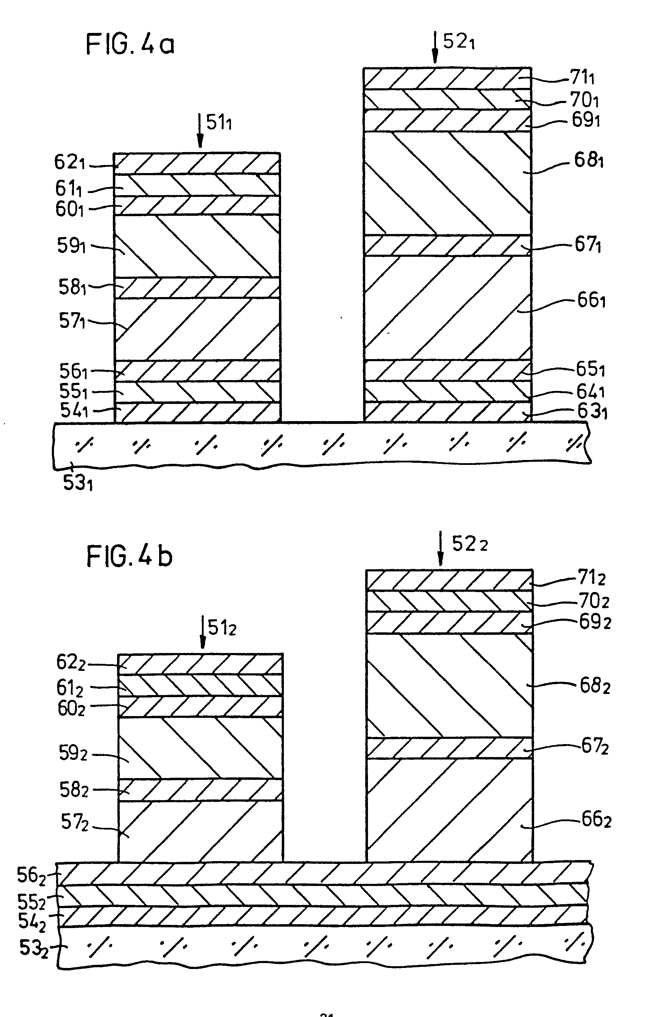

In Fig. 4a bis 4d sind Aufzeichnungsträger mit induzierten Transmissionsfiltern in Form von Schichtpaketen $51_1$-$51_4$ für einen ersten Farbton und von Schichtpaketen $52_1$-$52_4$ für einen zweiten Farbton dargestellt. Das Schichtpaket $51_1$ auf einem Schichtträger $53_1$ besteht aus einer hochbrechenden absorptionsfreien Schicht $54_1$, einer niedrigbrechenden absorptionsfreien Schicht $55_1$, einer hochbrechenden absorptionsfreien Schicht $56_1$, einer ersten anorganischen absorptionsfreien Interferenzschicht $57_1$ gemäss dem ersten Farbton, einer Metallschicht $58_1$, einer zweiten anorganischen absorptionsfreien Interferenzschicht $59_1$ gemäss dem ersten Farbton, einer hochbrechenden absorptionsfreien Schicht $60_1$, einer niedrigbrechenden absorptionsfreien Schicht $61_1$ und einer hochbrechenden absorptionsfreien Schicht $62_1$; die Schichten $54_1$-$62_1$ bilden den strukturbildenden Teil des Schichtpakets $51_1$. Das Schichtpaket $52_1$ auf dem Schichtträger $53_1$ besteht aus einer hochbrechenden absorptionsfreien Schicht $63_1$, einer niedrigbrechenden absorptionsfreien Schicht $64_1$, einer hochbrechenden absorptionsfreien Schicht $65_1$, einer ersten anorganischen absorptionsfreien Interferenzschicht $66_1$ gemäss dem zweiten Farbton, einer Metallschicht $67_1$, einer zweiten anorganischen absorptionsfreien Interferenzschicht $68_1$ gemäss dem zweiten Farbton, einer hochbrechenden absorptionsfreien Schicht $69_1$, einer niedrigbrechenden absorptionsfreie Schicht $70_1$ und einer hochbrechenden absorptionsfreien Schicht $71_1$; die Schichten $63_1$-$71_1$ bilden den strukturbildenden Teil des Schichtpakets $52_1$.

Das Schichtpaket $51_2$ auf einem Schichtträger $53_2$ besteht aus einer ganzflächigen hochbrechenden absorptionsfreien Schicht $54_2$, einer ganzflächigen niedrigbrechenden absorptionsfreien Schicht $55_2$, einer ganzflächigen hochbrechenden absorptionsfreien Schicht $56_2$, einer ersten anorganischen absorptionsfreien Interferenzschicht $57_2$ gemäss dem ersten Farbton, einer Metallschicht $58_2$, einer zweiten anorganischen absorptionsfreien Interferenzschicht $59_2$ gemäss dem ersten Farbton, einer hochbrechenden absorptionsfreien Schicht $60_2$, einer niedrigbrechenden absorptionsfreien Schicht $61_2$ und einer hochbrechenden absorptionsfreien Schicht $62_2$; die Schichten $57_2$-$62_2$ bilden den strukturbildenden Teil des Schichtpakets $51_2$, während die ganzflächigen Schichten $54_2$-$56_2$ nicht zur Strukturbildung beitragen. Das Schichtpaket $52_2$ auf dem Schichtträger $53_2$ besteht aus der ganzflächigen hochbrechenden absorptionsfreien Schicht $54_2$, der ganzflächigen niedrigbrechenden absorptionsfreien Schicht $55_2$, der ganzflächigen hochbrechenden absorptionsfreien Schicht $56_2$, einer ersten anorganischen absorptionsfreien Interferenzschicht $66_2$ gemäss dem zweiten Farbton, einer Metallschicht $67_2$, einer zweiten anorganischen absorptionsfreien Interferenzschicht $68_2$ gemäss dem zweiten Farbton, einer hochbre-

chenden absorptionsfreien Schicht $69_2$, einer niedrigbrechenden absorptionsfreien Schicht $70_2$ und einer hochbrechenden absorptionsfreien Schicht $71_2$; die Schichten $66_2$-$71_2$ bilden den strukturbildenden Teil des Schichtpakets $52_2$, während die ganzflächigen Schichten $54_2$-$56_2$ nicht zur Strukturbildung beitragen. Die Aufzeichnungsträger gemäss Fig. 4a, 4b werden auf photolithographischem Weg in der vorgehend beschriebenen Weise erzeugt.

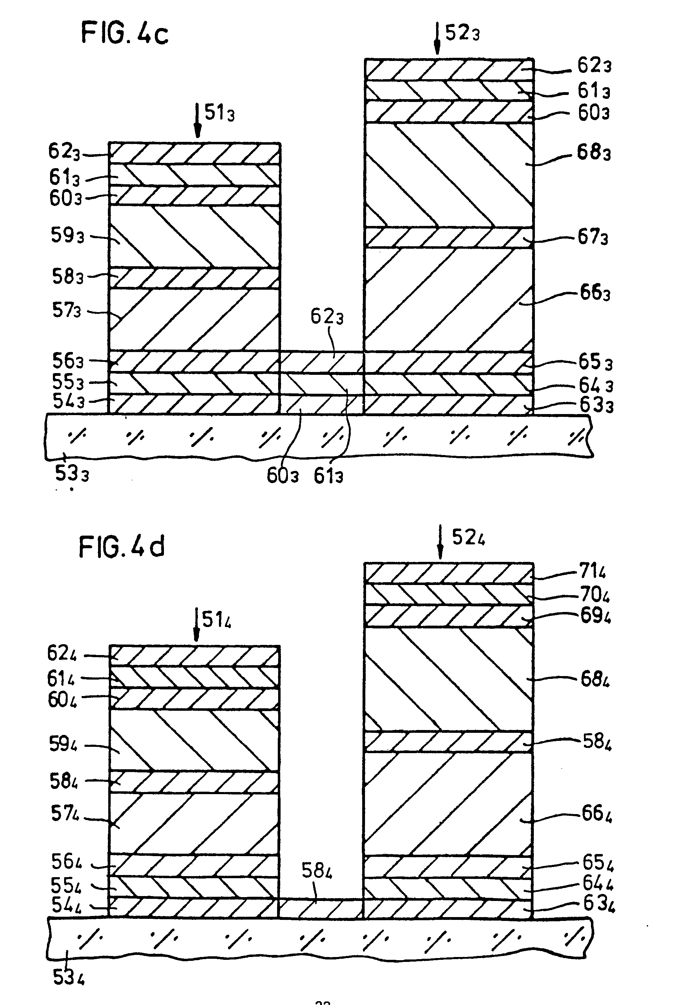

In einer anderen Ausbildung dieses Aufzeichnungsträgers wird nach Fig. 4c zur Erzeugung des ersten Farbtons auf einem Schichtträger $53_3$, in nicht gezeigter Weise ganzflächig eine erste Photolackschicht aufgebracht und mittels der ersten Belichtungsmaske belichtet. Nach dem Entwickeln der ersten Photolackschicht werden auf dem Schichtträger $53_3$ ganzflächig eine hochbrechende absorptionsfreie Schicht $54_3$, eine niedrigbrechende absorptionsfreie Schicht $55_3$, eine hochbrechende absorptionsfreie Schicht $56_3$, eine erste anorganische absorptionsfreie Interferenzschicht $57_3$ gemäss dem ersten Farbton, eine Metallschicht $58_3$ und eine zweite anorganische absorptionsfreie Interferenzschicht $59_3$ gemäss dem ersten Farbton aufgebracht. Die verbliebene erste Photolackschicht mitsamt den darüber befindlichen Schichten $54_3$-$59_3$ wird sodann entfernt. Zur Erzeugung des zweiten Farbtons wird auf dem Schichtträger $53_3$ ganzflächig eine zweite Photolackschicht aufgebracht und mittels der zweiten Belichtungsmaske belichtet. Nach dem Entwickeln der zweiten Photolackschicht werden auf dem Schichtträger $53_3$ ganzflächig eine hochbrechende absorptionsfreie Schicht $63_3$, eine niedrigbrechende absorptionsfreie Schicht $64_3$, eine hochbrechende absorptionsfreie Schicht $65_3$, eine erste anorganische absorptionsfreie Interferenzschicht $66_3$ gemäss dem zweiten Farbton, eine Metallschicht $67_3$ und eine zweite anorganische absorptionsfreie Interferenzschicht $68_3$ gemäss dem zweiten Farbton aufgebracht. Die verbliebene zweite Photolackschicht mitsamt dem darüber befindlichen Schichten $63_3$-$68_3$ wird sodann entfernt. Auf dem Schichtträger $53_3$ befinden sich somit die strukturbildenden Schichten $54_3$-$59_3$ des Schichtpakets $51_3$ für den ersten Farbton und die strukturbildenden Schichten $63_3$-$68_3$ des Schichtpakets $52_3$ für den zweiten Farbton. Anschliessend werden auf dem Schichtträger $53_3$ ganzflächig eine hochbrechende absorptionsfreie Schicht $60_3$, eine niedrigbrechende absorptionsfreie Schicht $61_3$ und eine hochbrechende absorptionsfreie Schicht $62_3$ aufgebracht. Die ganzflächigen Schichten $60_3$-$62_3$ tragen nicht zur Strukturbildung bei.

In einer weiteren Ausbildung dieses Aufzeichnungsträgers wird nach Fig. 4d zur Erzeugung des ersten Farbtons auf einem Schichtträger $53_4$ in nicht gezeigter Weise ganzflächig eine erste Photolackschicht aufgebracht und mittels der ersten Belichtungsmaske belichtet. Nach dem Entwickeln der ersten Photolackschicht werden auf dem Schichtträger $53_4$ ganzflächig eine hochbrechende absorptionsfreie Schicht $54_4$, eine niedrigbrechende absorptionsfreie Schicht $55_4$, eine hochbrechende absorptionsfreie Schicht $56_4$ und eine erste anorganische absorptionsfreie Interferenzschicht $57_4$ gemäss dem ersten Farbton aufgebracht. Die verbliebene erste Photolackschicht mitsamt den darüber befindlichen Schichten $54_4$-$57_4$ wird sodann entfernt. Zur Erzeugung des zweiten Farbtons wird auf dem Schichtträger $53_4$ ganzflächig eine zweite Photolackschicht aufgebracht und mittels der zweiten Belichtungsmaske belichtet. Nach dem Entwickeln der zweiten Photolackschicht werden auf dem Schichtträger $53_4$ ganzflächig eine hochbrechende absorptionsfreie Schicht $63_4$, eine niedrigbrechende absorptionsfreie Schicht $64_4$, eine hochbrechende absorptionsfreie Schicht $65_4$ und eine erste anorganische absorptionsfreie Interferenzschicht $66_4$ gemäss dem zweiten Farbton aufgebracht. Die verbliebene zweite Photolackschicht mitsamt den darüber befindlichen Schichten $63_4$-$66_4$ wird sodann entfernt. Auf dem Schichtträger $53_4$ befinden sich somit der erste Teil der strukturbildenden Schichten $54_4$-$57_4$ des Schichtpakets $51_4$ für den ersten Farbton und der erste Teil der strukturbildenden Schichten $63_4$-$66_4$ des Schichtpakets $52_4$ für den zweiten Farbton. Anschliessend werden auf dem Schichtträger $53_4$ ganzflächig eine Metallschicht $58_4$, die nicht zur Strukturbildung beiträgt, und darüber zur Erzeugung des ersten Farbtons eine dritte Photolackschicht aufgebracht, die mittels der ersten Belichtungsmaske belichtet wird. Nach dem Entwickeln der dritten Photolackschicht werden auf der Metallschicht $58_4$ ganzflächig eine zweite anorganische absorptionsfreie Interferenzschicht $59_4$ gemäss dem ersten Farbton, eine hochbrechende absorptionsfreie Schicht $60_4$, eine niedrigbrechende absorptionsfreie Schicht $61_4$ und eine hochbrechende absorptionsfreie Schicht $62_4$ aufgebracht. Die verbliebene dritte Photolackschicht mitsamt den darüber befindlichen Schichten $59_4$-$62_4$ wird sodann entfernt. Zur Erzeugung des zweiten Farbtons wird auf der Metallschicht $58_4$ anschliessend ganzflächig eine vierte Photolackschicht aufgebracht und mittels der zweiten Belichtungsmaske belichtet. Nach dem Entwickeln der vierten Photolackschicht werden auf der Metallschicht $58_4$ ganzflächig eine zweite anorganische absorptionsfreie Interferenzschicht $68_4$ gemäss dem zweiten Farbton, eine hochbrechende absorptionsfreie Schicht $69_4$, eine niedrigbrechende absorptionsfreie Schicht $70_4$ und eine hochbrechende absorptionsfreie Schicht $71_4$ aufgebracht. Die verbliebene vierte Photolackschicht mitsamt den darüber befindlichen Schichten $68_4$-$71_4$ wird sodann entfernt. Auf der Metallschicht $58_4$ befinden sich somit der zweite Teil der strukturbildenden Schichten $59_4$-$62_4$ des Schichtpakets $51_4$ für den ersten Farbton und der zweite Teil der strukturbildenden Schichten $68_4$-$71_4$ des Schichtpakets $52_4$ für den zweiten Farbton. Die Metallschichten 58, 67 sind teildurchlässig Schichten.

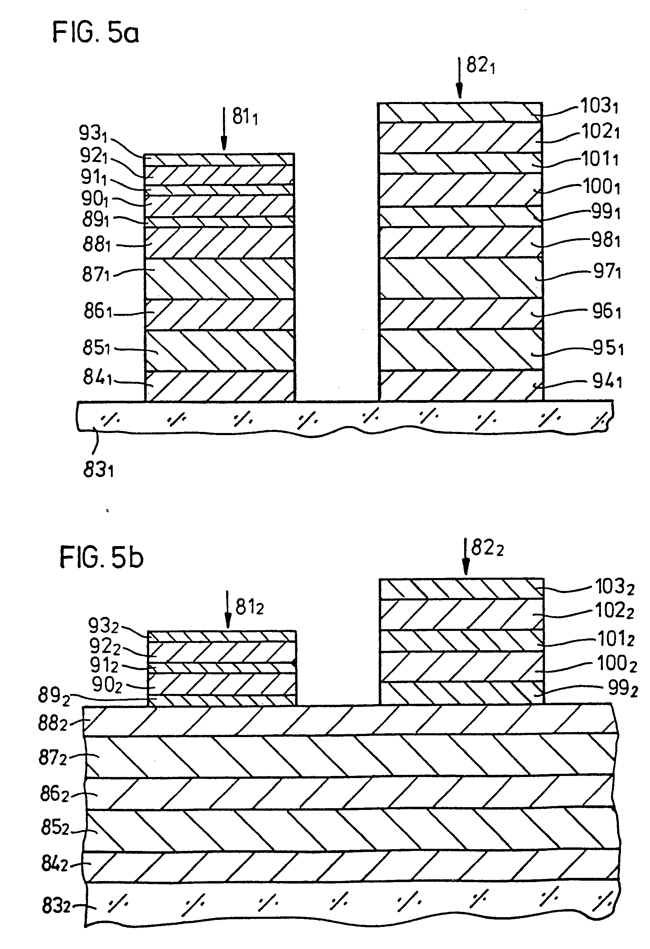

In Fig. 5a, 5b sind Aufzeichnungsträger mit Kantenfiltern in Form von Schichtpaketen $81_1$, $81_2$ für einen ersten Farbton und von Schichtpaketen $82_1$,

$82_2$ für einen zweiten Farbton dargestellt. Das Schichtpaket $81_1$ auf einem Schichtträger $83_1$ nach Fig. 5a besteht aus zwei übereinanderliegenden Kantenfiltern $84_1$-$88_1$; $89_1$-$93_1$, die aus hochbrechenden absorptionsfreien Schichten $84_1$, $86_1$, $88_1$; $89_1$, $91_1$, $93_1$ bestehen, zwischen denen sich niedrigbrechende absorptionsfreie Schichten $85_1$, $87_1$; $90_1$, $92_1$ befinden. Das Schichtpaket $82_1$ auf dem Schichtträger $83_1$ besteht aus zwei übereinanderliegenden Kantenfiltern $94_1$-$98_1$; $99_1$-$103_1$, die aus hochbrechenden absorptionsfreien Schichten $94_1$, $96_1$, $98_1$; $99_1$, $101_1$, $103_1$ bestehen, zwischen denen sich niedrigbrechende absorptionsfreie Schichten $95_1$, $97_1$; $100_1$, $102_1$ befinden. Die Schichten $84_1$-$93_1$ der beiden Kantenfilter $84_1$-$88_1$; $89_1$-$93_1$ bilden den strukturbildenden Teil des Schichtpakets $81_1$ und die Schichten $94_1$-$103_1$ der beiden Kantenfilter $94_1$-$98_1$; $99_1$-$103_1$ den strukturbildenden Teil des Schichtpakets $82_1$.

Das Schichtpaket $81_2$ auf einem Schichtträger $83_2$ nach Fig. 5b besteht aus zwei übereinanderliegenden Kantenfiltern $84_2$-$88_2$; $89_2$-$93_2$, von denen das Kantenfilter $84_2$-$88_2$ aus ganzflächigen hochbrechenden absorptionsfreien Schichten $84_2$, $86_2$, $88_2$, zwischen denen sich ganzflächige niedrigbrechende absorptionsfreie Schichten $85_2$, $87_2$ befinden, und das Kantenfilter $89_2$-$93_2$ aus hochbrechenden absorptionsfreien Schichten $89_2$, $91_2$, $93_2$ bestehen, zwischen denen sich niedrigbrechende absorptionsfreie Schichten $90_2$, $92_2$ befinden; das Kantenfilter $90_2$-$93_2$ bildet den strukturbildenden Teil des Schichtpakets $81_2$. Das Schichtpaket $82_2$ auf dem Schichtträger $83_2$ besteht aus dem ganzflächigen Kantenfilter $84_2$-$88_2$, über dem sich ein Kantenfilter $99_2$-$103_2$ befindet, das aus hochbrechenden absorptionsfreien Schichten $99_2$, $101_2$, $103_2$ besteht, zwischen denen sich niedrigbrechende absorptionsfreie Schichten $100_2$, $102_2$ befinden. Das Kantenfilter $99_2$-$103_2$ bildet den strukturbildenden Teil des Schichtpakets $82_2$; das ganzflächige Kantenfilter $84_2$-$88_2$ trägt nicht zur Strukturbildung der Schichtpakete $81_2$, $82_2$ bei.

Bei den Filtern 1, 2; 11, 12; 31, 32; 51, 52 werden die ersten und zweiten Farbtöne durch die optischen Dicken der Interferenzschichten 5, 8; 17, 24; 37, 42; 57, 59, 66, 68 und die Sättigung dieser Farbtöne durch das Reflexionsvermögen der Metallschichten 4, 6, 7, 9; 38, 43; 58, 67 bzw. der hochbrechenden Schichten 14, 16, 18, 20, 21, 23, 25, 27; 34, 36, 39, 41; 54, 56, 60, 62, 63, 65, 69, 71 und der niedrigbrechenden Schichten 15, 19, 22, 26; 35, 40; 55, 61, 64, 70 bestimmt.

Bei einem Kantenfilter (Reflektor) fällt der spektrale Bereich hoher Transmission über eine steile Flanke zu einem spektralen Bereich niedriger Transmission ab. Die optischen Schichtdicken der hochbrechenden und niedrigbrechenden Schichten eines Kantenfilters betragen $\lambda/4$, wobei $\lambda$ die grösste Wellenlänge der geringsten Transmission des Kantenfilters bedeutet. Die Kantenfilter $84_1$-$88_1$; $94_1$-$98_1$ nach Fig. 5a mögen im spektralen Bereich der zu erzeugenden beiden Farbtöne eine mit zunehmender Wellenlänge ansteigende Flanke der Transmission und die Kantenfilter $89_1$-$93_1$; $99_1$-$103_1$ in diesem Bereich eine abfallende Flanke der Transmission aufweisen; durch Überlagerung der Kantenfilter $84_1$-$88_1$; $94_1$-$98_1$ mit den Kantenfiltern $89_1$-$93_1$; $99_1$-$103_1$ wird ein Transmissionsmaximum für die beiden gewünschten Farbtöne erzielt.

Bei einem bestimmten Verhältnis von Schichtdicke der überlagerten Kantenfilter zum Durchmesser der Feinstruktur können jedoch Schwierigkeiten bei der Entfernung der verbliebenen Photolackschicht mitsamt den darauf befindlichen Kantenfiltern auftreten. Es wird daher vorgeschlagen, gemäss Fig. 5b den unteren Kantenfilter $84_2$-$88_2$ ganzflächig auszubilden und die überlagerten Kantenfilter $89_2$-$93_2$; $99_2$-$103_2$ allein zu strukturieren. Der ganzflächige Kantenfilter $84_2$-$88_2$ muss in bestimmten Wellenlängenbereichen eine möglichst hohe und konstante Transmission besitzen, was durch eine Variation der optischen Schichtdicken der hochbrechenden und niedrigbrechenden Schichten $84_2$-$88_2$ erreicht wird. Vorzugsweise unterscheiden sich dabei die optischen Schichtdicken etwa im Bereich von $\pm 10\%$ vom Betrag $\lambda/4$.

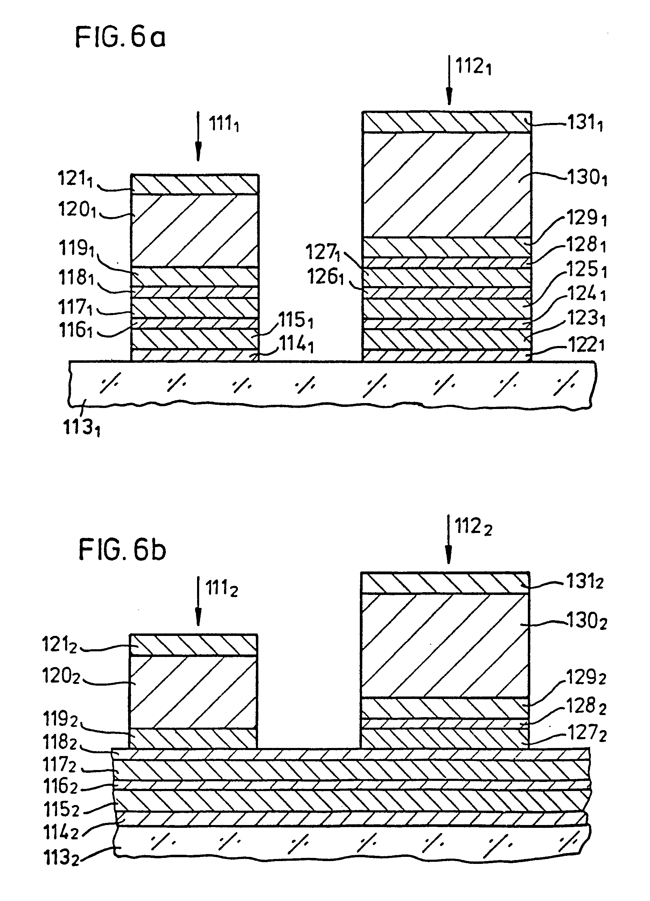

Derartige Schichtpakete können auch aus einer Kombination von Filtern 1, 2; 11, 12; 31, 32; 51, 52; 81, 82 bestehen. In Fig. 6a, 6b sind Aufzeichnungsträger mit Kantenfiltern und überlagerten metall-dielektrichen Interferenzfiltern in Form von Schichtpaketen $111_1$, $111_2$ für einen ersten Farbton und von Schichtpaketen $112_1$, $112_2$ für einen zweiten Farbton dargestellt. Das Schichtpaket $111_1$ auf einem Schichtträger $113_1$ nach Fig. 6a besteht aus einem Kantenfilter $114_1$-$118_1$ mit hochbrechenden absorptionsfreien Schichten $114_1$, $116_1$, $118_1$, zwischen denen sich niedrigbrechende absorptionsfreie Schichten $115_1$, $117_1$ befinden, und aus einem metall-dielektrischen Interferenzfilter $119_1$-$121_1$ mit einer Interferenzschicht $120_1$, die auf beiden Seiten durch anorganische spiegelnde Schichten $119_1$, $121_1$ begrenzt ist. Das Schichtpaket $112_1$ auf dem Schichtträger $113_1$ besteht aus einem Kantenfilter $122_1$-$128_1$ mit hochbrechenden absorptionsfreien Schichten $122_1$, $124_1$, $126_1$, $128_1$, zwischen denen sich niedrigbrechende absorptionsfreie Schichten $123_1$, $125_1$, $127_1$ befinden, und aus einem metall-dielektrischen Interferenzfilter $129_1$-$131_1$ mit einer Interferenzschicht $130_1$, die auf beiden Seiten durch anorganische spiegelnde Schichten $129_1$, $131_1$ begrenzt ist. Die Schichten $114_1$-$121_1$ bilden den strukturbildenden Teil des Schichtpakets $111_1$ und die Schichten $122_1$-$131_1$ den strukturbildenden Teil des Schichtpakets $112_1$.

Das Schichtpaket $111_2$ auf einem Schichtträger $113_2$ nach Fig. 6b besteht aus einem Kantenfilter $114_2$-$118_2$ mit ganzflächigen hochbrechenden absorptionsfreien Schichten $114_2$, $116_2$, $118_2$, zwischen denen sich ganzflächige niedrigbrechende absorptionsfreie Schichten $115_2$, $117_2$ befinden, und aus einem metall-dielektrischen Interferenzfilter $119_2$-$121_2$ mit einer Interferenzschicht $120_2$, die auf beiden Seiten durch anorganische spiegelnde Schichten $119_2$-$121_2$ begrenzt

ist; das metall-dielektrische Interferenzfilter $119_2$-$121_2$ bildet den strukturbildenden Teil des Schichtpakets $111_2$. Das Schichtpaket $112_2$ auf dem Schichtträger $113_2$ besteht aus den ganzflächigen Schichten $114_2$-$118_2$, aus einer niedrigbrechenden absorptionsfreien Schicht $127_2$, aus einer hochbrechenden absorptionsfreien Schicht $128_2$ und aus einem metall-dielektrischen Interferenzfilter $129_2$-$131_2$ mit einer Interferenzschicht $130_2$, die auf beiden Seiten durch anorganische spiegelnde Schichten $129_2$, $131_2$ begrenzt ist; die Schichten $127_2$, $128_2$ und das metall-dielektrische Interferenzfilter $129_2$-$131_2$ bilden den strukturbildenden Teil des Schichtpakets $112_2$.

Die anorganischen spiegelnden Schichten 4, 6, 7, 9; 38, 43; 58, 67; 119, 121, 129, 131 bestehen aus Ag, Cr, Au, Al oder aus einer Kombination dieser Materialien, die Interferenzschichten 5, 8; 17, 24; 37, 42; 57, 59, 66, 68; 120, 130 aus $MgF_2$, $SiO_2$, $Al_2O_3$, $Fe_2O_3$ oder aus Mischungen dieser Materialien, die hochbrechenden Schichten 14, 16, 18, 20, 21, 23, 25, 27; 34, 36, 39, 41; 54, 56, 60, 62, 63, 65, 69, 71; 84, 86, 88, 89, 91, 93, 94, 96, 98, 99, 101, 103; 114, 116, 118, 122, 124, 126, 128 aus $TiO_2$, $ZrO_2$, $HfO_2$, $Nd_2O_3$ oder aus Mischungen dieser Materialien und die niedrigbrechenden Schichten 15, 19, 22, 26; 35, 40; 55, 61, 64, 70; 85, 87, 90, 92, 95, 97, 100, 102; 115, 117, 123, 125, 127 aus $MgF_2$, $SiO_2$, $Al_2O_3$, $Fe_2O_3$ oder aus Mischungen dieser Materialien. Der Schichtträger 3; 13; 33; 53; 83; 113 kann aus durchsichtigem Material oder aus undurchsichtigem Material mit spiegelnder Oberfläche bestehen.

Die Schichtpakete 1, 2; 11, 12; 31, 32; 51, 52; 81, 82; 111, 112 und/oder strukturbildende Teile dieser Schichtpakete 1, 2; 11, 12; 31, 32; 51, 52; 81, 82; 111, 112 werden bevorzugt auf photolithographischem Wege nacheinander — und zwar in der Reihenfolge der Farbtöne der Feinstruktur — örtlich voneinander getrennt auf dem Schichtträger 3; 13; 33; 53; 83; 113 aufgebracht. Neben dem vorgehend beschriebenen photolithographischen Verfahren können die Schichtpakete und/oder die strukturbildenden Teile dieser Schichtpakete auf photolithographischem Wege mittels nasschemischer Ätzverfahren oder physikalischer Ätzverfahren wie Ionenstrahlätzen, Sputterätzen, Plasmaätzen oder reaktives Ionenätzen auf dem Schichtträger erzeugt werden. Des weiteren können die Schichtpakete und/oder die strukturbildenden Teile dieser Schichtpakete mittels jeweils einer Bedampfungsmaske oder mittels eines gesteuerten Teilchenstrahls (Elektronenstrahl, Ionenstrahl etc.) hergestellt werden.

Auf einem Schichtträger können auf einem Teil Schichtpakete mit teilweise ganzflächigen Schichten und auf einem anderen Teil Schichtpakete ohne ganzflächige Schichten — auch mit unterschiedlichen Herstellungsverfahren — erzeugt werden. Zwischen aneinandergrenzenden unterschiedlichen Schichtpaketen, die nacheinander erzeugt worden sind, ist ein Grenzbereich definiert, der eine örtliche Trennung dieser Schichtpakete darstellt.

Das Aufbringen der Schichten der Schichtpakete 1, 2; 11, 12; 31, 32; 51, 52; 81, 82; 111, 112 kann beispielsweise durch Aufdampfen, Sputtern, Ionenplattieren und Ausscheiden aus der Dampfphase erfolgen.

Die erfindungsgemässen Aufzeichnungsträger weisen insbesondere den Vorteil einer verbesserten Farbtonreinheit und Farbtonsättigung sowie einer Verminderung des Ausschusses auf.

Der vorgeschlagene Aufzeichnungsträger findet bevorzugt Verwendung zur Aufzeichnung mehrfarbiger Mikrolandkarten.

**Patentansprüche**

1. Aufzeichnungsträger mit einer mehrfarbigen Feinstruktur (Muster), insbesondere in Form einer Mikrolandkarte, mit wenigstens zwei optisch wirksamen, strukturbildenden Schichtpaketen für wenigstens zwei unterschiedliche Farbtöne auf einem Schichtträger, dadurch gekennzeichnet, dass die Schichtpakete (1, 2; 11, 12; 31, 32; 51, 52; 81, 82; 111, 112) jeweils aus wenigstens einem Interferenzfilter mit wenigsten einer strukturbildenden Abstandsschicht und/oder aus wenigstens einem Kantenfilter (Reflektor) bestehen und dass die Schichtpakete (1, 2; 11, 12; 31, 32; 51, 52; 81, 82; 111, 112) und/oder strukturbildende Teile dieser Schichtpakete (1, 2; 11, 12; 31, 32; 51, 52; 81, 82; 111, 112) nacheinander — und zwar in der Reihenfolge der Farbtöne der Feinstruktur — örtlich voneinander getrennt auf dem Schichtträger (3; 13; 33; 53; 83; 113) aufgebracht sind.

2. Aufzeichnungsträger nach Anspruch 1, dadurch gekennzeichnet, dass das Schichtpaket (81, 82) durch wenigstens ein Kantenfilter (Reflektor) gebildet ist.

3. Aufzeichnungsträger nach Anspruch 1, dadurch gekennzeichnet, dass das Schichtpaket (11, 12) durch wenigstens ein rein-dielektrisches Interferenzfilter gebildet ist.

4. Aufzeichnungsträger nach Anspruch 1, dadurch gekennzeichnet, dass das Schichtpaket (31, 32) durch wenigstens ein Halbfilter gebildet ist.

5. Aufzeichnungsträger nach Anspruch 1, dadurch gekennzeichnet, dass das Schichtpaket (51, 52) durch wenigstens ein induziertes Transmissionsfilter gebildet ist.

6. Aufzeichnungsträger nach Anspruch 1, dadurch gekennzeichnet, dass das Schichtpaket (1, 2) durch wenigstens ein metall-dielektrisches Interferenzfilter gebildet ist.

7. Aufzeichnungsträger nach den Ansprüchen 1 bis 6, dadurch gekennzeichnet, dass das Schichtpaket (111, 112) aus einer Kombination von Einzelpaketen in Form von übereinander angeordneten, unterschiedlichen Filtern besteht.

8. Aufzeichnungsträger nach Anspruch 1, dadurch gekennzeichnet, dass das Schichtpaket (1, 2; 11, 12; 31, 32; 51, 52; 81, 82; 111, 112) aus wenigstens einer im Gesamtbereich des Schichtträgers (3; 13; 33; 53; 83; 113) ganzflächig aufgebrachten Schicht und aus wenigstens einer gemäss der Aufzeichnung strukturierten Schicht besteht.

9. Aufzeichnungsträger nach Anspruch 8, dadurch gekennzeichnet, dass der sich ganzflächig über den Schichtträger (3; 13; 33; 53; 83; 113) erstreckende nicht strukturbildende Teil der Schichtpakete (1, 2; 11, 12; 31, 32; 51, 52; 81, 82; 111, 112) aus wenigstens einem Filter und/oder aus einem Teil eines Filters besteht.

10. Aufzeichnungsträger nach Anspruch 6, dadurch gekennzeichnet, dass das metall-dielektrische Interferenzfilter (1, 2) aus einer anorganischen absorptionsfreien Interferenzschicht (5, 8) besteht, die auf jeder Seite durch wenigstens eine anorganische spiegelnde Schicht (4, 6, 7, 9) begrenzt ist.

11. Aufzeichnungsträger nach Anspruch 3, dadurch gekennzeichnet, dass das rein-dielektrische Interferenzfilter (11, 12) aus einer anorganischen absorptionsfreien Interferenzschicht (17, 24) besteht, die auf jeder Seite durch wenigstens eine hochbrechende absorptionsfreie Schicht (14, 16, 18, 20, 21, 23, 25, 27) begrenzt ist, wobei sich zwischen je zwei hochbrechenden Schichten (14, 16, 18, 20, 21, 23, 25, 27) eine niedrigbrechende absorptionsfreie Schicht (15, 19, 22, 26) befindet.

12. Aufzeichnungsträger nach Anspruch 4, dadurch gekennzeichnet, dass das Halbfilter (31, 32) aus einer anorganischen absorptionsfreien Interferenzschicht (37, 42) besteht, die auf einer Seite von wenigstens einer anorganischen spiegelnden Schicht (38, 43) und auf der anderen Seite durch wenigstens eine hochbrechende absorptionsfreie Schicht (34, 36, 39, 41) begrenzt ist, wobei sich zwischen je zwei hochbrechenden Schichten (34, 36, 39, 41) eine niedrigbrechende absorptionsfreie Schicht (35, 40) befindet.

13. Aufzeichnungsträger nach Anspruch 5, dadurch gekennzeichnet, dass das induzierte Transmissionsfilter (51, 52) aus zwei anorganischen absorptionsfreien Interferenzschichten (57, 59, 66, 68) besteht, zwischen denen sich wenigstens eine anorganische spiegelnde Schicht (58, 67) befindet und die jeweils auf der anderen Seite durch wenigstens eine hochbrechende absorptionsfreie Schicht (54, 56, 60, 62, 63, 65, 69, 71) begrenzt ist, wobei sich zwischen je zwei hochbrechenden Schichten (54, 56, 60, 62, 63, 65, 69, 71) eine niedrigbrechende absorptionsfreie Schicht (55, 61, 64, 70) befindet.

14. Aufzeichnungsträger nach Anspruch 2, dadurch gekennzeichnet, dass das Kantenfilter (81, 82) aus wenigstens einer hochbrechenden absorptionsfreien Schicht (84, 86, 88, 89, 91, 93, 94, 96, 98, 99, 101, 103) besteht, wobei sich zwischen je zwei hochbrechenden Schichten (84, 86, 88, 89, 91, 93, 94, 96, 98, 99, 101, 103) eine niedrigbrechende absorptionsfreie Schicht (85, 87, 90, 92, 95, 97, 100, 102) befindet.

15. Aufzeichnungsträger nach Anspruch 2, dadurch gekennzeichnet, dass die optischen Schichtdicken der einzelnen Schichten der Kantenfilter (81, 82) sich vom Betrag $\lambda/4$ ($\lambda$ = grösste Wellenlänge der geringsten Transmission eines Kantenfilters) unterscheiden.

16. Aufzeichnungsträger nach Anspruch 15, dadurch gekennzeichnet, dass die optischen Schichtdicken der einzelnen Schichten der Kantenfilter (81, 82) sich etwa im Bereich $\pm 10\%$ vom Betrag $\lambda/4$ unterscheiden.

17. Aufzeichnungsträger nach den Ansprüchen 10, 12 und 13, dadurch gekennzeichnet, dass die anorganischen spiegelnden Schichten (4, 6, 7, 9; 38, 43; 58, 67; 119, 121, 129, 131) aus Ag, Cr, Au, Al oder aus einer Kombination dieser Materialien bestehen.

18. Aufzeichnungsträger nach den Ansprüchen 10 bis 13, dadurch gekennzeichnet, dass die Interferenzschicht (5, 8; 17, 24; 37, 42; 57, 59, 66, 68; 120, 130) aus $MgF_2$, $SiO_2$, $Al_2O_3$, $Fe_2O_3$ oder aus Mischungen dieser Materialien bestehen.

19. Aufzeichnungsträger nach den Ansprüchen 11 bis 14, dadurch gekennzeichnet, dass die hochbrechenden Schichten (14, 16, 18, 20, 21, 23, 25, 27; 34, 36, 39, 41; 54, 56, 60, 62, 63, 65, 69, 71; 84, 86, 88, 89, 91, 93, 94, 96, 98, 99, 101, 103; 114, 116, 118, 122, 124, 126, 128) aus $TiO_2$, $ZrO_2$, $HfO_2$, $Nd_2O_3$ oder aus Mischungen dieser Materialien und die niedrigbrechenden Schichten (15, 19, 22, 26; 35, 40; 55, 61, 64, 70; 85, 87, 90, 92, 95, 97, 100, 102; 115, 117, 123, 125, 127) aus $MgF_2$, $SiO_2$, $Al_2O_3$, $Fe_2O_3$ oder aus Mischungen dieser Materialien bestehen.

20. Aufzeichnungsträger nach Anspruch 1, dadurch gekennzeichnet, dass der Schichtträger (3; 13; 33; 53; 83; 113) aus einem durchsichtigen Material oder aus einem undurchschtigen Material mit spiegelnder Oberfläche besteht.

21. Verfahren zur Herstellung des Aufzeichnungsträgers nach Anspruch 1, dadurch gekennzeichnet, dass die Schichtpakete (1, 2; 11, 12; 31, 32; 51, 52; 81, 82; 111, 112) und/oder strukturbildenden Teile dieser Schichtpakete (1, 2; 11, 12; 31, 32; 51, 52; 81, 82; 111, 112) auf photolithographischem Weg nacheinander auf dem Schichtträger (3; 13; 33; 53; 83; 113) erzeugt werden.

22. Verfahren zur Herstellung des Aufzeichnungsträgers nach Anspruch 1, dadurch gekennzeichnet, dass die Schichtpakete (1, 2; 11, 12; 31, 32; 51, 52; 81, 82; 111, 112) und/oder strukturbildenden Teile dieser Schichtpakete (1, 2; 11, 12; 31, 32; 51, 52; 81, 82; 111, 112) mittels jeweils einer Bedampfungsmaske nacheinander auf dem Schichtträger (3; 13; 33; 53; 83; 113) erzeugt werden.

23. Verfahren zur Herstellung des Aufzeichnungsträgers nach Anspruch 1, dadurch gekennzeichnet, dass die Schichtpakete (1, 2; 11, 12; 31, 32; 51, 52; 81, 82; 111, 112) und/oder strukturbildenden Teile dieser Schichtpakete (1, 2; 11, 12; 31, 32; 51, 52; 81, 82; 111, 112) mittels eines gesteuerten Teilchenstrahls nacheinander auf dem Schichtträger (3; 13; 33; 53; 83; 113) erzeugt werden.

24. Verfahren zur Herstellung des Aufzeichnungsträgers nach Anspruch 21 durch sukzessive Erzeugung der einzelnen Schichtpakete auf dem Schichtträger, gekennzeichnet durch folgende Verfahrensschritte zur Erzeugung jedes einzelnen Schichtpakets:

a) auf dem Schichtträger ($3_1$; $13_1$; $33_1$; $53_1$; $83_1$; $113_1$) wird ganzflächig eine Photolack-

schicht aufgebracht und mittels einer Belichtungsmaske für das jeweilige Schichtpakete ($1_1$, $2_1$; $11_1$, $12_1$; $31_1$, $32_1$; $51_1$, $52_1$; $81_1$, $82_1$; $111_1$, $112_1$) belichtet;

b) nach dem Entwickeln der Photolackschicht werden nacheinander die Schichten des Schichtpakets ($1_1$, $2_1$; $11_1$, $12_1$; $31_1$, $32_1$; $51_1$, $52_1$; $81_1$, $82_1$; $111_1$, $112_1$) ganzflächig auf dem Schichtträger ($3_1$; $13_1$; $33_1$; $53_1$; $83_1$; $113_1$) aufgebracht;

c) die verbliebene Photolackschicht wird sodann mitsamt den darauf befindlichen Schichten des Schichtpakets ($1_1$, $2_1$; $11_1$, $12_1$; $31_1$, $32_1$; $51_1$, $52_1$; $81_1$, $82_1$; $111_1$, $112_1$) entfernt.

25. Verfahren zur Herstellung des Aufzeichnungsträgers nach Anspruch 21 durch sukzessive Erzeugung der einzelnen Schichtpakete auf dem Schichtträger, gekennzeichnet durch folgende Verfahrensschritte zur Erzeugung jedes einzelnen Schichtpakets:

a) auf dem Schichtträger ($3_2$, $3_3$; $13_2$; $33_2$; $53_2$; $83_2$; $113_2$) werden ganzflächig die nicht strukturbildenden Schichten aller Schichtpakete ($1_2$, $1_3$; $2_2$, $2_3$; $11_2$, $12_2$; $31_2$, $32_2$; $51_2$, $52_2$; $81_2$, $82_2$; $111_2$, $112_2$) nacheinander aufgebracht;

b) anschliessend wird auf dem Schichtträger ($3_2$, $3_3$; $13_2$; $33_2$; $53_2$; $83_2$; $113_2$) ganzflächig eine Photolackschicht aufgebracht und mittels einer Belichtungsmaske für das jeweilige Schichtpaket ($1_2$, $1_3$; $2_2$, $2_3$; $11_2$, $12_2$; $31_2$, $32_2$; $51_2$, $52_2$; $81_2$, $82_2$; $111_2$, $112_2$) belichtet;

c) nach dem Entwickeln der Photolackschicht werden nacheinander die strukturbildenden Schichten des Schichtpakets ($1_2$, $1_3$; $2_2$, $2_3$; $11_2$, $12_2$; $31_2$, $32_2$; $51_2$, $52_2$; $81_2$, $82_2$; $111_2$, $112_2$) ganzflächig auf dem Schichtträger ($3_2$, $3_3$; $13_2$; $33_2$; $53_2$; $83_2$; $113_2$) aufgebracht;

d) die verbliebene Photolackschicht wird sodann mitsamt den darauf befindlichen strukturbildenden Schichten des Schichtpakets ($1_2$, $1_3$; $2_2$, $2_3$; $11_2$, $12_2$; $31_2$, $32_2$; $51_2$, $52_2$; $81_2$, $82_2$; $111_2$, $112_2$) entfernt.

26. Verfahren zur Herstellung des Aufzeichnungsträgers nach Anspruch 21 durch sukzessive Erzeugung der einzelnen Schichtpakete auf dem Schichtträger, gekennzeichnet durch folgende Verfahrensschritte zur Erzeugung jedes einzelnen Schichtpakets:

a) auf dem Schichtträger ($53_3$) wird ganzflächig eine Photolackschicht aufgebracht und mittels einer Belichtungsmaske für das jeweilige Schichtpaket ($51_3$, $52_3$) belichtet;

b) nach dem Entwickeln der Photolackschicht werden nacheinander die strukturbildenden Schichten des Schichtpakets ($51_3$, $52_3$) ganzflächig auf dem Schichtträger ($53_3$) aufgebracht;

c) die verbliebene Photolackschicht wird sodann mitsamt den darauf befindlichen strukturbildenden Schichten des Schichtpakets ($51_3$, $52_3$) entfernt;

d) auf dem Schichtträger ($53_3$) werden anschliessend ganzflächig die nicht strukturbildenden Schichten der Schichtpakete ($51_3$, $52_3$) nacheinander aufgebracht.

27. Verfahren zur Herstellung des Aufzeichnungsträgers nach Anspruch 21 durch sukzessive Erzeugung der einzelnen Schichtpakete auf dem Schichtträger, gekennzeichnet durch folgende Verfahrensschritte zur Erzeugung jedes einzelnen Schichtpakets:

a) auf dem Schichtträger ($53_4$) wird ganzflächig eine erste Photolackschicht aufgebracht und mittels einer Belichtungsmaske für das jeweilige Schichtpaket ($51_4$, $52_4$) belichtet;

b) nach dem Entwickeln der Photolackschicht wird der erste Teil der strukturbildenden Schichten des Schichtpakets ($51_4$, $52_4$) ganzflächig auf dem Schichtträger ($53_4$) aufgebracht;

c) die verbliebene Photolackschicht wird sodann mitsamt dem darauf befindlichen ersten Teil der strukturbildenden Schichten des Schichtpakets ($51_4$, $52_4$) entfernt;

d) auf dem Schichtträger ($53_4$) werden ganzflächig die nicht strukturbildenden Schichten der Schichtpakete ($51_4$, $52_4$) nacheinander aufgebracht;

e) auf dem Schichtträger ($53_4$) wird anschliessend ganzflächig eine zweite Photolackschicht aufgebracht und mittels der Belichtungsmaske für das jeweilige Schichtpaket ($51_4$, $52_4$) belichtet;

f) nach dem Entwickeln der Photolackschicht wird der zweite Teil der strukturbildenden Schichten des Schichtpakets ($51_4$, $52_4$) ganzflächig auf dem Schichtträger ($53_4$) aufgebracht;

g) die verbliebene Photolackschicht wird sodann mitsamt dem darauf befindlichen zweiten Teil der strukturbildenden Schichten des Schichtpakets ($51_4$, $52_4$) entfernt.

28. Verfahren zur Herstellung des Aufzeichnungsträgers nach Anspruch 21, dadurch gekennzeichnet, dass die Schichtpakete (1, 2; 11, 12; 31, 32; 51, 52; 81, 82; 111, 112) und/oder strukturbildenden Teile dieser Schichtpakete (1, 2; 11, 12; 31, 32; 51, 52; 81, 82; 111, 112) mittels nasschemischer oder physikalischer Abtragungsmethoden nacheinander auf dem Schichtträger (3; 13; 33; 53; 83; 113) erzeugt werden.

## Revendications

1. Support d'enregistrement à structure fine polychrome (dessin), en particulier sous la forme d'une microcarte géographique, comprenant au moins deux paquets de couches optiquement efficaces, structurantes, pour au moins deux teintes différentes sur un seul support de couche, caractérisé par le fait que les paquets de couches (1, 2; 11, 12; 31, 32; 51, 52; 81, 82; 111, 112) sont composés respectivement par au moins un filtre interférentiel ayant au moins une couche structurante d'espacement et/ou par au moins un filtre de bordure (réflecteur), et par le fait que les paquets de couches (1, 2; 11, 12; 31, 32; 51, 52; 81, 82; 111, 112) et/ou des parties structurantes de ces paquets de couches (1, 2; 11, 12; 31, 32; 51, 52; 81, 82, 111, 112) sont appliqués sur le support de couches (3, 13; 33; 53; 83; 113), successivement, à savoir dans l'ordre des teintes chromatiques de la structure fine, et de façon séparée localement les uns des autres.

2. Support d'enregistrement selon la revendication 1, caractérisé par le fait que le paquet de couches (81, 82) est constitué par au moins un filtre de bordure (réflecteur).

3. Support d'enregistrement selon la revendication 1, caractérisé par le fait que le paquet de couches (11, 12) est constitué par au moins un filtre interférentiel purement diélectrique.

4. Support d'enregistrement selon la revendication 1, caractérisé par le fait que le paquet de couches (31, 32) est constitué par au moins un filtre semi-transparent.

5. Support d'enregistrement selon la revendication 1, caractérisé par le fait que le paquet de couches (51, 52) est constitué par au moins un filtre de transmission induit.

6. Support d'enregistrement selon la revendication 1, caractérisé par le fait que le paquet de couches (1, 2) est constitué par au moins un filtre interférentiel en métal diélectrique.

7. Support d'enregistrement selon l'une des revendications 1 à 6, caractérisé par le fait que le paquet de couches (111, 112) est contitué par une combinaison de paquets individuels formant des filtres différents, disposés en superposition.

8. Support d'enregistrement selon la revendication 1, caractérisé par le fait que le paquet de couches (1, 2; 11, 12; 31, 32; 51, 52; 81, 82; 111, 112) est constitué par au moins une couche appliquée sur toute la surface dans la totalité de la zone du support de couches (3; 13; 33; 53; 83; 113) et par au moins une couche structurée conformément à l'enregistrement.

9. Support d'enregistrement selon la revendication 8, caractérisé par le fait que la partie non structurante des paquets de couches (1, 2; 11, 12; 31, 32; 51, 52; 81, 82; 111, 112) s'étendant sur toute la surface sur le support des couches (1, 3, 13; 33; 53; 83; 113), est constituée par au moins un filtre et/ou une partie d'un filtre.

10. Support d'enregistrement selon la revendication 6, caractérisé par le fait que le filtre interférentiel en métal diélectrique (1, 2) est constitué par une couche interférentielle (5, 8) inorganique, exempte d'absorption, qui est délimitée de chaque côté par au moins une couche réfléchissante inorganique (4, 6, 7, 9).

11. Support d'enregistrement selon la revendication 3, caractérisé par le fait que le filtre interférentiel purement diélectrique (11, 12) est constitué par une couche interférentielle inorganique exempte d'absorption (17, 24) qui est limitée de chaque côté par au moins une couche exempte d'absorption à indice de réfraction élevé (14, 16, 18, 20, 21, 23, 25, 27), une couche exempte d'absorption à indice de réfraction bas (15, 19, 22, 26) se trouvant placée entre chaque fois deux couches à indice de réfraction élevé (14, 16, 18, 20, 21, 23, 25, 27).

12. Support d'enregistrement selon la revendication 4, caractérisé par le fait que le demi-filtre (31, 32) est constitué par une couche interférentielle (37, 42) inorganique exempte d'absorption, qui est délimitée d'un côté par au moins une couche inorganique réfléchissante (38, 43) et de l'autre côté par au moins une couche à indice de réfraction élevé, exempte d'absorption (34, 36, 39, 41), une couche à indice de réfraction bas exempte d'absorption (35, 40) se trouvant placée entre chaque fois deux couches à indice de réfraction élevé (34, 36, 39, 41).

13. Support d'enregistrement selon la revendication 5, caractérisé par le fait que le filtre de transmission induit (51, 52) est constitué par deux couches interférentielles inorganiques exemptes d'absorption (57, 59, 66, 68), entre lesquelles se trouve au moins une couche réfléchissante inorganique (58, 67) et qui est délimitée de l'autre côté, respectivement, par au moins une couche exempte d'absorption à indice de réfraction élevé (54, 56, 60, 62, 63, 65, 71), une couche à indice de réfraction bas exempte d'absorption (55, 61, 64, 70) se trouvant placée entre deux couches à indice de réfraction élevé (54, 56, 60, 62, 63, 65, 69, 71) respectivement.

14. Support d'enregistrement selon la revendication 2, caractérisé par le fait que le filtre de bordure (81, 82) est constitué par au moins une couche exempte d'absorption à indice de réfraction élevé (84, 86, 88, 89, 91, 93, 94, 96, 98, 99, 101, 103), une couche à indice de réfraction bas exempte d'absorption (85, 87, 90, 92, 95, 97, 100, 102) se trouvant placée entre deux couches à indice de réfraction élevée (84, 86, 88, 89, 91, 93, 94, 96, 98, 99, 101, 103) respectivement.

15. Support d'enregistrement selon la revendication 2, caractérisé par le fait que les épaisseurs de couche optique des différentes couches du filtre de bordure (81, 82) sont différentes du nombre $\lambda/4$ ($\lambda$ = plus grande longueur d'onde de la plus faible transmission d'un filtre de bordure).

16. Support d'enregistrement selon la revendication 15, caractérisé par le fait que les épaisseurs de couche optiques des différentes couches des filtres de bordure (81, 82) sont différentes de la valeur $\lambda/4$ d'environ $\pm 10\%$.

17. Support d'enregistrement selon les revendications 10, 12 et 13, caractérisé par le fait que les couches réfléchissantes inorganiques (4, 6, 7, 9; 38, 43; 58, 67; 119, 121, 129, 131) sont constituées de Ag, Cr, Au, Al, ou d'une combinaison de ces matériaux.

18. Support d'enregistrement selon l'une des revendications 10 à 13, caractérisé par le fait que les couches interférentielles (5, 8; 17, 24; 37, 42; 57, 59, 66, 68; 120, 130) sont constituées de $MgF_2$, $SiO_2$, $Al_2O_3$, $Fe_2O_3$ ou de mélanges de ces matériaux.

19. Support d'enregistrement selon l'une des revendications 11 à 14, caractérisé par le fait que les couches à indice de réfraction élevé (14, 16, 18, 20, 21, 23, 25, 27; 34, 36, 39, 41; 54, 56, 60, 62, 63, 65, 69, 71; 84, 86, 88, 89, 91, 93, 94, 96, 99, 101, 103; 114, 116, 118, 122, 124, 126, 128) sont constituées de $TiO_2$, $ZrO_2$, $HfO_2$, $Nd_2O_3$ ou de mélanges de ces matériaux, et les couches à bas indice de réfraction (15, 19, 22, 26; 35, 40; 55, 61, 64, 70; 85, 87, 90, 92, 95, 97, 100, 102; 115, 117, 123, 125, 127) sont constituées de $MgF_2$, $SiO_2$, $Al_2O_3$, $Fe_2O_3$ ou de mélanges de ces matériaux.

20. Support d'enregistrement selon la revendication 1, caractérisé par le fait que le support de couches (3; 13; 33; 53; 83; 113) est constitué en une matière transparente ou en une matière non transparente à surface réfléchissante.

21. Procédé pour la fabrication du support d'enregistrement selon la revendication 1, caractérisé par le fait que les paquets de couches (1, 2; 11, 12; 31, 32; 51, 52; 81, 82; 111, 112) et/ou parties structurantes de ces paquets de couches (1, 2; 11, 12; 31, 32; 51, 52; 81, 82; 111, 112) sont produits par voie photolithographique successivement sur le support de couches (3; 13; 33; 53; 83; 113).

22. Procédé pour la fabrication du support d'enregistrement conforme à la revendication 1, caractérisé par le fait que les paquets de couches (1, 2; 11, 12; 31, 32; 51, 52; 81, 83; 111, 112) et/ou parties structurantes de ces paquets de couches (1, 2; 11, 12; 31, 32; 51, 52; 81, 82; 111, 112) sont produits respectivement, au moyen d'un masque de vaporisation, successivement sur le support de couches (3; 13; 33; 53; 83; 113).

23. Procédé pour la fabrication du support d'enregistrement selon la revendication 1, caractérisé par le fait que les paquets de couches (1, 2; 11, 12; 31, 32; 51, 52; 81, 82; 111, 112) et/ou parties structurantes de ces paquets de couches (1, 2; 11, 12; 31, 32; 51, 52; 81, 82; 111, 112) sont produits au moyen d'un rayon de particules commandé, successivement sur le support de couches (3; 13; 33; 53; 83; 113).

24. Procédé pour la fabrication du support d'enregistrement selon la revendication 21, par production successive des différents paquets de couches sur le support de couches, caractérisé par le fait qu'il comprend les opérations suivantes pour la production de chaque paquet de couches:

a) sur la surface totale du support de couches ($3_1$; $13_1$; $33_1$; $53_1$; $113_1$) on applique une couche de vernis photosensible et on expose à la lumière à travers un masque d'exposition conçu pour le paquet de couches respectif ($1_1$, $2_1$; $11_1$, $12_1$; $31_1$, $32_1$; $51_1$, $52_1$; $81_1$, $82_1$; $111_1$, $112_1$);

b) après le développement de la couche de vernis photosensible on applique successivement les couches du paquet de couches ($1_1$, $2_1$; $11_1$, $12_1$; $31_1$, $32_1$; $51_1$, $52_1$; $81_1$, $82_1$; $111_1$, $112_1$) sur l'ensemble de la surface du support de couches ($3_1$; $13_1$; $33_1$; $53_1$; $83_1$; $113_1$);

c) la couche de vernis photosensible restante est alors éliminée en même temps que les couches qui s'y trouvent du paquet de couches ($1_1$, $2_1$; $11_1$, $12_1$; $31_1$, $32_1$; $51_1$, $52_1$; $81_1$, $82_1$; $111_1$, $112_1$).

25. Procédé pour la fabrication du support d'enregistrement selon la revendication 21 par production successive des différents paquets de couches sur le support de couches, caractérisé par les opérations suivantes pour la production de chaque paquet de couches:

a) sur le support de couches ($3_2$, $3_3$; $13_2$; $33_2$; $53_2$; $83_2$; $113_2$) on applique successivement, sur l'ensemble de la surface, les couches non structurantes de tous les paquets de couches ($1_2$, $1_3$; $2_2$, $2_3$; $11_2$, $12_2$; $31_2$, $32_2$; $51_2$, $52_2$; $81_2$, $82_2$; $111_2$, $112_2$);

b) on applique ensuite sur toute la surface du support de couches ($3_2$, $3_3$; $13_2$; $33_2$; $53_2$; $83_2$; $113_2$) une couche de vernis photosensible et on l'expose à la lumière à travers un masque d'exposition destiné aux paquets de couches respectifs ($1_2$, $1_3$; $2_2$, $2_3$; $11_2$, $12_2$; $31_2$, $32_2$; $51_2$, $52_2$; $81_2$, $82_2$; $111_2$, $112_2$);

c) après le développement de la couche de vernis photosensible on applique, successivement, sur toute la surface du support de couches ($3_2$; $3_3$; $13_2$; $33_2$; $53_2$; $83_2$; $113_2$) les couches structurantes du paquet de couches ($1_2$, $1_3$; $2_2$, $2_3$; $11_2$, $12_2$; $31_2$, $32_2$; $51_2$, $52_2$; $81_2$, $82_2$; $111_2$, $112_2$);

d) la couche de vernis photosensible restante est ensuite éliminée en même temps que les couches structurantes qui s'y trouvent du paquet de couches ($1_2$, $1_3$; $2_2$, $2_3$; $11_2$, $12_2$; $31_2$, $32_2$; $51_2$, $52_2$; $81_2$, $82_2$; $111_2$, $112_2$).

26. Procédé pour la fabrication du support d'enregistrement selon la revendication 21, par production successive des différents paquets de couches sur le support de couches, caractérisé par les opérations suivantes pour la production de chaque paquet de couches:

a) sur le support de couches ($53_3$) on applique sur l'ensemble de la surface une couche de vernis photosensible et on l'expose à la lumière à travers un masque destiné au paquet de couches respectif ($51_3$, $52_3$);

b) après le développement de la couche de vernis photosensible on applique successivement les couches structurantes du paquet de couches ($51_3$, $52_3$) sur toute la surface du support de couches ($53_3$);

c) la couche de vernis photosensible restante est ensuite éliminée en même temps que les couches structurantes qui s'y trouvent du paquet de couches ($51_3$, $52_3$);

d) sur le support de couche ($53_3$) on applique ensuite sur l'ensemble de la surface les couches non structurantes des paquets de couches ($51_3$, $52_3$).

27. Procédé pour la fabrication du support d'enregistrement selon la revendication 21 par production successive des différents paquets de couches sur le support de couches, caractérisé par les opérations suivantes pour la production de chaque paquet de couches:

a) sur le support de couches ($53_4$) on applique sur l'ensemble de la surface une première couche de vernis photosensible et on l'expose à la lumière à travers un masque destiné au paquet de couches respectif ($51_4$, $52_4$);

b) après le développement de la couche de vernis photosensible on applique la première partie des couches structurantes du paquet de couches ($51_4$, $52_4$) sur toute la surface du support de couches ($53_4$);

c) la couche de laque photosensible restante est ensuite éliminée en même temps que la première partie qui s'y trouve des couches structurantes du paquet de couches ($51_4$, $52_4$);

d) sur le support de couches ($53_4$) on applique, sur l'ensemble de la surface, les couches non structurantes des paquets de couches (51₄, 52₄) successivement;

e) sur le support de couches (53₄) on applique ensuite sur l'ensemble de la surface une deuxième couche de vernis photosensible et on l'expose à la lumière à travers un masque destiné au paquet de couches respectif (51₄, 52₄);

f) après le développement de la couche de vernis photosensible on applique la deuxième partie des couches structurantes du paquet de couches (51₄, 52₄) sur toute la surface du support de couches (53₄);

g) on élimine ensuite la couche de vernis photosensible restante en même temps que la deuxième partie des couches structurantes qui s'y trouvent du paquet de couches (51₄, 52₄).

28. Procédé pour la fabrication du support d'enregistrement selon la revendication 21, caractérisé par le fait que les paquets de couches (1, 2; 11, 12; 31, 32; 51, 52; 81, 82; 111, 112) et/ou parties structurantes de ces paquets de couches (1, 2; 11, 12; 31, 32; 51, 52; 81, 82; 111, 112) sont produits au moyen de procédés d'attaque physiques ou chimiques par voie humide successivement, sur le support de couches (3; 13; 33; 53; 83; 113).

**Claims**

1. Recording medium having a polychromatic microstructure (pattern) particularly in the form of a micromap, comprising at least two optically effective, structure-forming layered stacks for at least two different hues on a layer base, characterised in that the layered stacks (1, 2; 11, 12; 31, 32; 51, 52; 81, 82; 111, 112) consist in each case of at least one interference filter having at least one structure-forming spacing layer and/or of at least one cut-off filter (reflector) and that the layered stacks (1, 2; 11, 12; 31, 32; 51, 52; 81, 82; 111, 112) and/or structure-forming parts of these layered stacks (1, 2; 11, 12; 31, 32; 51, 52; 81, 82; 111, 112) are successively and in the sequence of the hues of the microstructure applied locally separated from each other to the layer base (3; 13; 33; 53; 83; 113).

2. Recording medium according to Claim 1, characterised in that the layered stack (81, 82) is formed by at least one cut-off filter (reflector).

3. Recording medium according to Claim 1, characterised in that the layered stack (11, 12) is formed by at least one purely dielectric interference filter.

4. Recording medium according to Claim 1, characterised in that the layered stack (31, 32) is formed by at least one half-filter.

5. Recording medium according to Claim 1, characterised in that the layered stack (51, 52) is formed by at least one induced transmission filter.

6. Recording medium according to Claim 1, characterised in that the layered stack (1, 2) is formed by at least one metal-dielectric interference filter.

7. Recording medium to Claims 1-6, characterised in that the layered stack (111, 112) consists of a combination of single stacks in the form of different filters arranged above each other.

8. Recording medium according to Claim 1, characterised in that the layered stack (1, 2; 11, 12; 31, 32; 51, 52; 81, 82; 111, 112) consists of at least one layer which is applied over the entire are in the total area of the layer base (3; 13; 33; 53; 83; 113) and of at least one layer which is structured in accordance with the recording.

9. Recording medium according to Claim 8, characterised in that the part, which extend over the entire area of the layer base (3; 13; 33; 53; 83; 113) and is not structure-forming, of the layered stacks (1, 2; 11, 12; 31, 32; 51, 52; 81, 82; 111, 112) consists of at least one filter and/or of a part of one filter.

10. Recording medium according to Claim 6, characterised in that the metal-dielectric interference filter (1, 2) consists of an anorganic absorption-free interference layer (5, 8) which is bounded on each side by at least one inorganic reflecting layer (4, 6, 7, 9).

11. Recording medium according to Claim 3, characterised in that the purely dielectric interference filter (11, 12) consists of an inorganic absorption-free interference layer (17, 24) which is bounded on each side by at least one high-refraction absorption-free layer (14, 16, 18, 20, 21, 23, 25, 27), a low-refraction absorptionfree layer (15, 19, 22, 26) being located between each two high-refraction layers (14, 16, 18, 20, 21, 23, 25, 27).

12. Recording medium according to Claim 4, characterised in that the half-filter (31, 32) consists of an inorganic absorption-free interference layer (37, 42) which is bounded on one side by at least one inorganic reflecting layer (38, 43) and on the other side by at least one high-refraction absorption-free layer (34, 36, 39, 41), a low-refraction absorption-free layer (35, 40) being located between each two high-refraction layers (34, 36, 39, 41).

13. Recording medium according to Claim 5, characterised in that the induced transmission filter (51, 52) consists of two inorganic absorption-free interference layers (57, 59, 66, 68) between which at least one inorganic reflecting layer (58, 67) is located and which is in each case bounded on the other side by at least one high-refraction absorption-free layer (54, 56, 60, 62, 63, 65, 69, 71), a low-refraction absorption-free layer (55, 61, 64, 70) being located between each two high-refraction layers (54, 56, 60, 62, 63, 65, 69, 71).

14. Recording medium according to Claim 2, characterised in that the cut-off filter (81, 82) consists of at least one high-refraction absorption-free layer (84, 86, 88, 89, 91, 93, 94, 96, 98, 99, 101, 103), a low-refraction absorption-free layer (85, 87, 90, 92, 95, 97, 100, 102) being located between each two high-refraction layers (84, 86, 88, 89, 91, 93, 94, 96, 98, 99, 101, 103).

15. Recording medium according to Claim 2, characterised in that the optical thicknesses of the individual layers of the cut-off filters (81, 82) differ from the value of $\lambda/4$ ($\lambda$ = longest wavelength of the least transmission of a cut-off filter).

16. Recording medium according to Claim 15, characterised in that the optical thicknesses of the individual layers of the cut-off filters (81, 82) differ from the value of $\lambda/4$ approximately within a range of $\pm 10\%$.

17. Recording medium according to Claims 10, 12 and 13, characterised in that the inorganic reflecting layers (4, 6, 7, 9; 38, 43; 58, 67; 119, 121, 129, 131) consist of Ag, Cr, Au, Al or of a combination of these materials.

18. Recording medium according to Claims 10-13 characterised in that the interference layers (5, 8; 17, 24; 37, 42; 57, 59, 66, 68; 120, 130) consist of $MgF_2$, $SiO_2$, $Al_2O_3$, $Fe_2O_3$ or of mixtures of these materials.

19. Recording medium according to Claims 11-14, characterised in that the high-refraction layers (14, 16, 18, 20, 21, 23, 25, 27; 34, 36, 39, 41; 54, 56, 60, 62, 63, 65, 69, 71; 84, 86, 88, 89, 91, 93, 94, 96, 98, 99, 101, 103; 114, 116, 118, 122, 124, 126, 128) consist of $TiO_2$, $ZrO_2$, $HfO_2$, $Nd_2O_3$ or of mixtures of these materials and the low-refraction layers (15, 19, 22, 26; 35, 40; 55, 61, 64, 70; 85, 87, 90, 92, 95, 97, 100, 102; 115, 117, 123, 125, 127) consist of $MgF_2$, $SiO_2$, $Al_2O_3$, $Fe_2O_3$ or of mixtures of these materials.

20. Recording medium according to Claim 1, characterised in that the layer base (3; 13; 33; 53; 83; 113) consists of a transparent material or of an opaque material having a reflecting surface.

21. Method for producing the recording medium according to Claim 1, characterised in that the layered stacks (1, 2; 11, 12; 31, 32; 51, 52; 81, 82; 111, 112) and/or structure-forming parts of these layered stacks (1, 2; 11, 12; 31, 32; 51, 52; 81, 82; 111, 112) are generated successively by photo-lithographic means on the layer base (3; 13; 33; 53; 83; 113).

22. Method for producing the recording medium according to Claim 1, characterised in that the layered stacks (1, 2; 11, 12; 31, 32; 51, 52; 81, 82; 111, 112) and/or structure-forming parts of these layered stacks (1, 2; 11, 12; 31, 32; 51, 52; 81, 82; 111, 112) are successively generated on the layer base (3; 13; 33; 53; 83; 113) by means of one vapour-deposition mask in each case.

23. Method for producing the recording medium according to Claim 1, characterised in that the layered stacks (1, 2; 11, 12; 31, 32; 51, 52; 81, 82; 111, 112) and/or structure-forming parts of these layered stacks (1, 2; 11, 12; 31, 32; 51, 52; 81, 82; 111, 112) are successively generated on the layer base (3; 13; 33; 53; 83; 113) by means of a controlled particle beam.

24. Method for producing the recording medium according to Claim 21, by successively generating the individual layered stacks on the layer base, characterised by the following method steps for generating each individual layered stack:

(a) a layer of photosensitive resist is applied over the entire area of the layer base $(3_1; 13_1; 33_1; 53_1; 83_1; 113_1)$ and exposed by means of an exposure mask for the respective layered stack $(1_1, 2_1; 11_1, 12_1; 31_1, 32_1; 51_1, 52_1; 81_1, 82_1; 111_1, 112_1)$;

(b) after the photosensitive resist layer has been developed, the layers of the layered stack $(1_1, 2_1; 11_1, 12_1; 31_1, 32_1; 51_1, 52_1; 81_1, 82_1; 111_1, 112_1)$ are successively applied to the entire area of the layer base $(3_1; 13_1; 33_1; 53_1; 83_1; 113_1)$;

(c) the remaining layer of photosensitive resist is then removed, together with the layers of the layered stacks $(1_1, 2_1; 11_1, 12_1; 31_1, 32_1; 51_1, 52_2; 81_1, 82_1; 111_1, 112_1)$ located on it.

25. Method for producing the recording medium according to Claim 21 by successively generating the individual layered stacks on the layer base, characterised by the following method steps for generating each individual layered stack:

(a) the non-structure-forming layers of all layered stacks $(1_2, 1_3; 2_2, 2_3; 11_2, 12_2; 31_2, 32_2; 51_2, 52_2; 81_2, 82_2; 111_2, 112_2)$ are successively applied to the entire area of the layer base $(3_2, 3_3; 13_2; 33_2; 53_2; 83_2; 113_2)$;

(b) following this, a layer of photosensitive resist is applied to the entire area of the layer base $(3_2, 3_3; 13_2; 33_2; 53_2; 83_2; 113_2)$ and exposed by means of an exposure mask for the respective layer stack $(1_2, 1_3; 2_2, 2_3; 11_2, 12_2; 31_2, 32_2; 51_2, 52_2; 81_2, 82_2; 111_2, 112_2)$;

(c) after the layer of photosensitive resist has been developed, the structure-forming layers of the layered stacks $(1_2, 1_3; 2_2, 2_3; 11_2, 12_2; 31_2, 32_2; 51_2, 52_2; 81_2, 82_2; 111_2, 112_3)$ are applied over the entire area of the layer base $(3_2, 3_3; 13_2; 33_2; 53_2; 83_2; 113_2)$;

(d) the remaining layer of photosensitive resist is then removed, together with the structure-forming layers of the layered stack $(1_2, 1_3; 2_2, 2_3; 11_2, 12_2; 31_2, 32_2; 51_2, 52_2; 81_2, 82_2; 111_2, 112_2)$ located on it.

26. Method for producing the recording medium according to Claim 21 by successively generating the individual layered stacks on the layer base, characterised by the following method steps for generating each individual layered stack:

(a) a layer of photosensitive resist is applied to the entire area of the layer base $(53_3)$ and exposed by means of an exposure mask for the respective layered stack $(51_3, 52_3)$;

(b) after the layer of photosensitive resist has been developed, the structure-forming layers of the layered stack $(51_3, 52_3)$ are successively applied to the entire area of the layer base $(53_3)$;

(c) the remaining layer of photosensitive resist is then removed, together with the structure-forming layers of the layered stack $(51_3, 52_3)$ located on it;

(d) the non-structuring-forming layers of the layered stacks $(51_3, 52_3)$ are then successively applied to the entire area of the layer base $(53_3)$.

27. Method for producing the recording medium according to Claim 21 by successively generating the individual layered stacks on the layer base, characterised by the following method steps for generating each individual layered stack;

(a) a first layer of photosensitive resist is applied to the entire area of the layer base $(53_4)$ and exposed by means of an exposure mask for the respective layered stack $(51_4, 52_4)$;

(b) after the layer of photosensitive resist has been developed, the first part of the structure-forming layers of the layered stack ($51_4$, $52_4$) is applied to the entire area of the layer base ($53_4$);

(c) the remaining layer of photosensitive resist is then removed, together with the first part of the structure-forming layers of the layered stack ($51_4$, $52_4$) located on it;

(d) the non-structure-forming layers of the layered stacks ($51_4$, $52_4$) are then successively applied to the entire area of the layer base ($53_4$);

(e) a second layer of photosensitive resist is then applied to the entire area of the layer base ($53_4$) and exposed by means of the exposure mask for the respective layered stack ($51_4$, $52_4$);

(f) after the layer of photosensitive resist has been developed, the second part of the structure-forming layers of the layered stack ($51_4$, $52_4$) is applied to the entire area of the layer base ($53_4$);

(g) the remaining layer of photosensitive resist is then removed, together with the second part of the structure-forming layers of the layer stack ($51_4$, $52_4$) located on it.

28. Method for producing the recording medium according to Claim 21, characterised in that the layered stacks (1, 2; 11, 12; 31, 32; 51, 52; 81, 82; 111, 112) and/or structure-forming parts of these layered stacks (1, 2; 11, 12; 31, 32; 51, 52; 81, 82; 111, 112) are successively generated on the layer base (3; 13; 33; 53; 83; 113) by means of wet-chemical or physical erosion methods.

# FIG. 1a

# FIG. 1b

# FIG. 1c

FIG. 2a

FIG. 2b

## FIG. 3a

## FIG. 3b

# FIG. 4a

# FIG. 4b

# FIG. 4c

# FIG. 4d

## FIG. 5a

## FIG. 5b

**FIG. 6a**

**FIG. 6b**